# EUROPEAN PATENT APPLICATION

(11) **EP 4 661 063 A1**
(43) Date of publication of application: **10.12.2025**
(21) Application number: 23919817.9
(22) Date of filing: 21.08.2023
(51) Int. Cl.: H01L 21/56

(54) **SEALING RESIN USED FOR COMPRESSION MOLDING, AND FORMING METHOD FOR SAME**

(30) Priority: 30.01.2023 JP 2023011559
(71) Applicant: Apic Yamada Corporation, Chikuma-shi, Nagano 389-0898 (JP)
(72) Inventor: WAKUI, Masaaki, Chikuma-shi, Nagano 389-0898 (JP); SAITO, Takashi, Chikuma-shi, Nagano 389-0898 (JP); KAWAGUCHI, Makoto, Chikuma-shi, Nagano 389-0898 (JP); NOMURA, Yudai, Chikuma-shi, Nagano 389-0898 (JP)
(74) Representative: Winter, Brandl - Partnerschaft mbB
(86) International application number: PCT/JP2023/029918
(87) International publication number: WO 2024/161681

(57) **Abstract**

The present invention addresses the problem of providing a sealing resin and a forming method for the same with which it is possible to achieve a compression molding device and a compression molding method capable of preventing the occurrence of molding defects. As the means for solving the problem, a sealing resin (R) according to the present invention is used in the compression molding of a workpiece (W) having a configuration in which an electronic component (Wb) is mounted on a base material (Wa), the sealing resin including a plate-shaped or block-shaped body (Ra), and legs (Rb) provided upright on one surface of the body (Ra), and the sealing resin being formed in a shape that does not make contact with the electronic component (Wb) when mounted on the base material (Wa).

## Description

### Technical Field

The present invention relates to a sealing resin for compression molding and a formation method thereof.

### Related Art

As an example of a resin sealing device and a resin sealing method for processing a workpiece, in which electronic parts are mounted on a substrate, into a molded product by sealing with sealing resin, those using a compression molding approach is known.

The compression molding approach is a technology for resin sealing by supplying a given amount of sealing resin to a sealing area (cavity) provided in a sealing mold composed of an upper mold and a lower mold, arranging a workpiece in the sealing area, and clamping with the upper mold and the lower mold. As one example, in the case of using a sealing mold with a cavity in the upper mold, a technology for molding by supplying sealing resin collectively to the center position on the workpiece is known. On the other hand, in the case of using a sealing mold with a cavity in the lower mold, a technology for molding by supplying a release film (hereinafter, may be simply referred to as "film") covering the mold face including the cavity and sealing resin is known (Patent Document 1: Japanese Patent Application Laid-Open Publication No. 2019-145550).

### Citation List

### Patent Literature

Patent Document 1: Japanese Patent Application Laid-Open Publication No. 2019-145550

### SUMMARY OF INVENTION

### Technical Problem

For example, in the case of resin sealing electronic parts (semiconductor chips) with wire-connections of a strip type as a workpiece, in the compression molding approach where a cavity is provided in the upper mold, there was a problem that resin sealing is difficult because the wire part of the workpiece held on the lower mold contacts and deforms due to the sealing resin supplied in advance to the cavity or the sealing resin supplied on the workpiece. Therefore, generally, a compression molding approach was adopted in which the workpiece is held on the upper mold, the cavity is provided in the lower mold, and sealing resin (as one example, granular resin) is supplied into the cavity.

However, in the configuration where the workpiece is held on the upper mold and the cavity is provided in the lower mold, there was a problem that when the workpiece is thin or large, it is difficult to hold it on the upper mold and it tends to fall. Moreover, normally, the configuration is such that sealing resin is supplied into the cavity of the lower mold with a film interposed, but when trying to form a molded product with a thickness (here, the thickness of the resin portion after molding) exceeding 1mm, there was a problem that the molding stroke becomes large, making it easy for molding failures to occur where the film bites into the molded product. Furthermore, when granular resin is configured as the sealing resin, the above-mentioned film biting is likely to occur. In addition, besides the problems of dust generation and difficult handling, there was a problem that it is difficult to supply (scatter) sealing resin evenly to the entire area of the cavity provided in the lower mold, resulting in uneven scattering. Moreover, there was a problem that molding failures easily occur where air contained in the gaps between particles during the scattering of sealing resin remains in the molded product without being released. Especially in the case of a workpiece where electronic parts are mounted by wire-connection, there was also a risk of wire flow (deformation or cutting of wires) due to resin flow in the cavity during resin sealing.

### Solution to Problem

The present invention has been made in view of the above circumstances, and aims to provide a sealing resin that is easy to handle and can realize a compression molding device and a compression molding method capable of solving the problem in a configuration where a cavity is provided in the lower mold by adopting a configuration where a cavity is provided in the upper mold, preventing the occurrence of molding failures due to resin flow, uneven scattering, residual air, dust generation, and formation of molded products with large thickness dimensions, and a formation method for the sealing resin.

The present invention solves the aforementioned problems by the solution described below as one embodiment.

A sealing resin according to one embodiment is configured for compression molding of a workpiece having a configuration in which electronic components are mounted on a substrate, and is required to be formed in a shape that does not contact the electronic components when placed on the substrate. As an example, the sealing resin includes a plate-shaped or block-shaped main body part, and legs erected on one face of the main body part. Therefore, for example, it is possible to perform resin sealing by a compression molding approach in which a cavity is provided in the upper mold, even for a workpiece or the like having strip-type wire-connected electronic components (semiconductor chips).

In addition, the leg are erected at positions that do not contact the electronic components when placed on the substrate, and are formed at a height that ensures a distance where the main body part does not contact the electronic components. Specifically, the legs are formed protrusions arranged wholly or partly in a dot shape. Alternatively, the legs are formed as protrusions arranged wholly or partly in a line shape. Alternatively, the legs are formed as protrusions arranged to continuously or intermittently surround over an entire periphery.

Furthermore, it includes a line-shaped groove part provided through the other face of the main body part and serving as a dicing position.

Furthermore, a formation method for sealing resin according to one embodiment forms a sealing resin for compression molding of a workpiece having a configuration in which electronic components are mounted on a substrate. The formation method is required to include a formation step of forming into a shape having a plate-shaped or block-shaped main body part and legs erected on the main body part. The formation step includes a step of forming by setting a position and a height of the legs such that neither the legs nor the main body part contacts the electronic components when the sealing resin is placed on the substrate.

### Effects of Invention

According to the sealing resin of the present invention, it is possible to realize a compression molding device and a compression molding method capable of solving the problem in a configuration where a cavity is provided in the lower mold by adopting a configuration where a cavity is provided in the upper mold, preventing the occurrence of molding failures due to resin flow, uneven scattering, residual air, dust generation, and formation of molded products with large thickness dimensions. In addition, handling during supply or setting becomes particularly easy compared to granular resin, etc.

### BRIEF DESCRIPTION OF DRAWINGS

[FIG. 1] FIG. 1 is a plan view showing an example of a compression molding device in which a sealing resin according to an embodiment of the present invention is configured.
[FIG. 2] FIG. 2 is a side view showing an example of a press device of the compression molding device of FIG. 1.
[FIG. 3] FIG. 3 is a front sectional view showing an example of a sealing mold of the compression molding device of FIG. 1.
[FIG. 4] FIG. 4 is an explanatory diagram of a compression molding method using the compression molding device of FIG. 1.
[FIG. 5] FIG. 5A is an enlarged view of part V in FIG. 4. FIG. 5B is an explanatory diagram following FIG. 5A.
[FIG. 6] FIG. 6 is an explanatory diagram following FIG. 5B.
[FIG. 7] FIG. 7 is an explanatory diagram following FIG. 6.
[FIG. 8] FIG. 8 is a perspective view showing an example of a sealing resin according to an embodiment of the present invention.
[FIG. 9] FIG. 9 is a perspective view showing another example of a sealing resin according to an embodiment of the present invention.
[FIG. 10] FIG. 10 is a perspective view showing another example of a sealing resin according to an embodiment of the present invention.
[FIG. 11] FIG. 11 is a perspective view showing another example of a sealing resin according to an embodiment of the present invention.

### DESCRIPTION OF THE EMBODIMENTS

### (Overall Configuration)

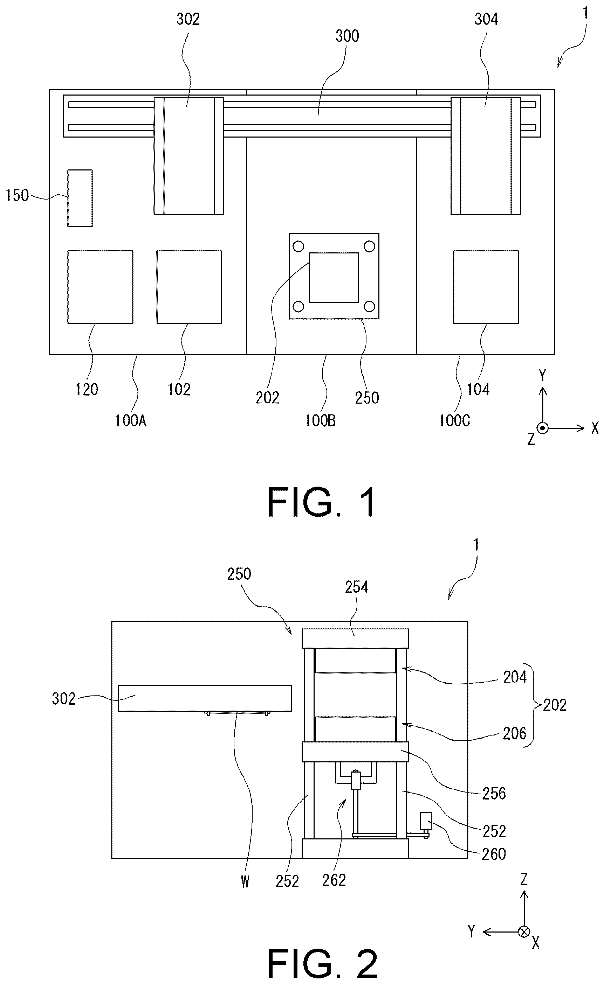

Hereinafter, with reference to the drawings, an embodiment of the present invention will be described in detail. FIG. 1 is a plan view (schematic diagram) showing an example of a compression molding device 1 in which a sealing resin R according to the present embodiment is configured. For convenience of explanation, in the figure, arrows indicate the left-right direction (X direction), front-back direction (Y direction), and up-down direction (Z direction) in the compression molding device 1. Moreover, in all figures for explaining each embodiment, the same reference numerals are assigned to members having the same function, and repeated explanations thereof may be omitted.

The compression molding device 1 is a device that performs resin sealing (compression molding) of a workpiece (object to be molded) W using a sealing mold 202 including an upper mold 204 and a lower mold 206. One or multiple workpiece holding parts 205 for holding a workpiece W are provided on the lower mold 206. One or multiple cavities 208 are provided on the upper mold 204 according to the shape or number of the workpiece W. A film F is suction-held inside the cavity 208. However, the present invention is not limited to such configuration.

First, the workpiece W, which is the object to be molded, includes a configuration in which electronic parts Wb are mounted on a substrate Wa. More specifically, examples of the substrate Wa include plate-shaped members such as resin substrates, ceramic substrates, metal substrates, carrier plates, lead frames, wafers, etc. Moreover, examples of the electronic parts Wb include semiconductor chips, MEMS chips, passive elements, heat dissipation plates, conductive members, spacers, etc. The shape of the substrate Wa is rectangular (strip-shaped), square, circular, etc. Moreover, the number of the electronic parts Wb mounted on one substrate Wa is set to one or multiple (for example, in a matrix arrangement, etc.).

Examples of methods for mounting the electronic parts Wb on the substrate Wa include methods using wire bonding mounting, flip chip mounting, etc. Alternatively, in a configuration where the substrate (glass or metal carrier plate) Wa is peeled off from a molded product Wp after resin sealing, there is also a method of attaching the electronic parts Wb using a thermally peelable adhesive tape or ultraviolet-curable resin that cures upon ultraviolet irradiation.

In the present embodiment, as a sealing resin R, a solid or semi-solid resin that is a thermosetting resin (for example, epoxy resin containing fillers, but not limited thereto) having a given shape whose overall shape (details to be described later) corresponds to the shape of the workpiece W is configured. Normally, one piece constitutes the "overall" of the required sealing amount (one time per workpiece W), but the configuration in which several pieces (for example, about two or three pieces) in a divided state constitute the "overall" of the required sealing amount may be adopted. The term "semi-solid" refers to a state that is not completely solid but melted to a so-called B-stage.

Moreover, as examples of the film F, film materials with excellent heat resistance, easy peelability, flexibility, and extensibility are preferably used, such as PTFE (polytetrafluoroethylene), ETFE (polytetrafluoroethylene copolymer), PET, FEP, fluorine-impregnated glass cloth, polypropylene, polyvinylidene chloride, etc.

Next, an overview of the compression molding device 1 in which the sealing resin R according to this embodiment is configured will be described. As shown in FIG. 1, the compression molding device 1 includes, as its main components, a supply unit 100A that performs supply of the workpiece W, etc., a press unit 100B that performs resin sealing of the workpiece W and processing it into the molded product Wp, etc., and a storage unit 100C that performs storage of the molded product Wp, etc. As one example, along the X direction in FIG. 1, the supply unit 100A, the press unit 100B, and the storage unit 100C are arranged in this order. However, the present invention is not limited to such configuration, and the equipment configuration within the units, the number of units (especially the number of press units), and the arrangement order of the units may be changed. In addition, a configuration including units other than those mentioned above (all not shown) may also be adopted.

Moreover, the compression molding device 1 includes a resin supply part 120 that performs supply of the sealing resin R. The resin supply part 120 is, as one example, located in the supply unit 100A, but may be configured to be located in the storage unit 100C or the press unit 100B (not shown). Alternatively, as another example, the resin supply part 120 may be configured to be located outside the compression molding device 1, and conveyed into the device using a conveyor such as a belt conveyor or a robot hand (not shown).

Moreover, the compression molding device 1 also has guide rails 300 linearly provided across the units, and a conveyor (first loader) 302 that conveys the workpiece W and the sealing resin R, as well as a conveyor (second loader) 304 that conveys the molded product Wp, are provided to be movable between given units along the guide rails 300. However, the present invention is not limited to the above configuration, and may be configured to include a common (single) conveyor (loader) that conveys the workpiece W, the sealing resin R, and the molded product Wp (not shown). Moreover, the conveyor may be configured to include a robot hand, etc. instead of a loader.

Moreover, the compression molding device 1 includes a control part 150 located in the supply unit 100A (it may also be configured to be located in other units) that performs operation control of each mechanism in each unit.

### (Supply Unit)

Next, the supply unit 100A included in the compression molding device 1 will be described in detail.

The supply unit 100A includes a supply magazine 102 in which multiple workpieces W are stored. Here, known stack magazines, slit magazines, etc. are configured as the supply magazine 102.

In addition, the supply unit 100A may be configured to include a workpiece stage (not shown) on which the workpiece W taken out from the supply magazine 102 is placed. Moreover, the supply unit 100A may be configured to include a resin stage (not shown) on which the sealing resin R supplied from the resin supply part 120 is placed.

The workpiece W and the sealing resin R are held by the first loader 302 and conveyed to the press unit 100B, and set at given positions in the sealing mold 202. In this embodiment, the workpiece W is held in a workpiece holding part 205 of the lower mold 206, and the sealing resin R is placed on top of the workpiece W held in the workpiece holding part 205 (details of the step will be described later). Moreover, as the holding mechanism for the workpiece W and the sealing resin R in the first loader 302, a known holding mechanism (for example, a configuration having holding claws for gripping, a configuration having suction holes communicating with a suction device to adsorb, etc.) is configured (not shown).

As a modification example of the above conveyor, the configuration may be such that instead of the first loader 302 that moves in the X and Y directions, a conveyor (loader) that moves in the X direction to perform conveyance between units and a conveyor (loader) that moves in the Y direction to perform loading and setting into the sealing mold 202 (not shown) are separately included.

In addition, the supply unit 100A includes a preheater (not shown) that performs preheating of the workpiece W and the sealing resin R. As one example, known heating mechanisms (for example, electric heating wire heaters, infrared heaters, etc.) are configured for the preheater. This allows the workpiece W and the sealing resin R to be preheated before being loaded into the sealing mold 202. A configuration not including a preheater may be adopted. Moreover, the configuration may be such that in the first loader 302, a heater for preheating (not shown) is provided instead of the preheater or together with the preheater.

### (Press Unit)

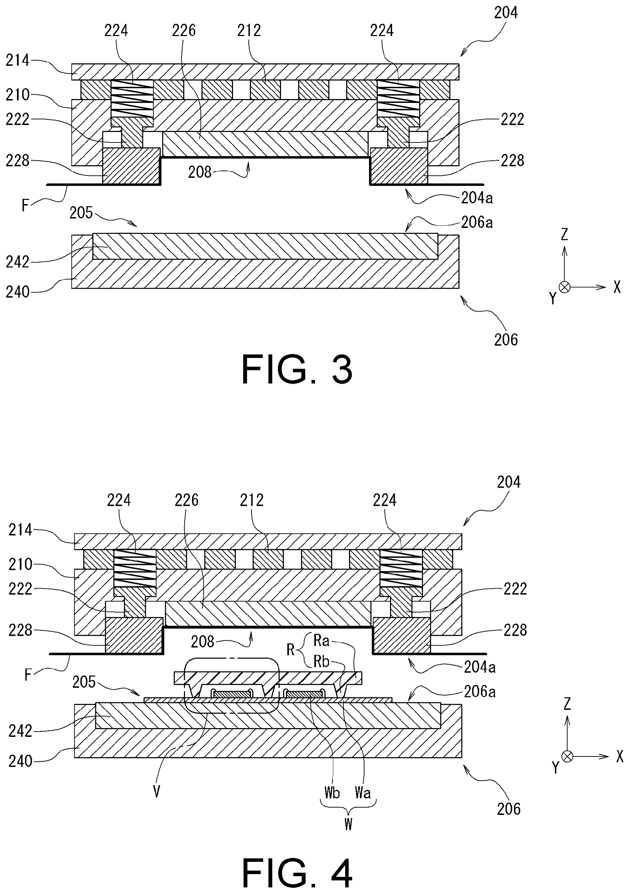

Next, the press unit 100B included in the compression molding device 1 will be described in detail. Here, FIG. 2 shows a side view (schematic diagram) of a press device 250 provided in the press unit 100B, and FIG. 3 shows a front cross-sectional view (schematic diagram) of the sealing mold 202.

The press unit 100B includes a sealing mold 202 having a pair of molds that open and close (for example, assembled with multiple mold blocks made of alloy tool steel, mold plates, mold pillars, etc., and other components). It also includes a press device 250 that drives the sealing mold 202 to open and close to perform resin sealing of the workpiece W. As one example, the configuration includes one press device 250, but may include multiple press devices (not shown).

Here, as shown in FIG. 2, the press device 250 is configured to include a pair of platens 254, 256, multiple tiebars 252 on which the pair of platens 254, 256 are mounted, and a drive device that makes the platen 256 movable (up and down). Specifically, the drive device is configured to include a drive source (for example, an electric motor) 260 and a drive transmission mechanism (for example, a ball screw or toggle link mechanism) 262, etc. (however, the present invention is not limited thereto). In this embodiment, the platen 254 on the upper side in the vertical direction is set as a fixed platen (a platen fixed to the tiebars 252), and the platen 256 on the lower side is set as a movable platen (a platen that moves up and down while being slidably held on the tiebars 252). However, the present invention is not limited to such configuration, and the arrangement may be reversed vertically. That is, the upper side may be set as the movable platen and the lower side as the fixed platen, or both the upper side and lower side may be set as movable platens (all not shown).

On the other hand, as shown in FIG. 3, the sealing mold 202 includes, as a pair of molds arranged between the pair of platens 254, 256 in the press device 250, one mold (upper mold 204) on the upper side in the vertical direction and another mold (lower mold 206) on the lower side. That is, the upper mold 204 is assembled to the upper platen (in this embodiment, the fixed platen 254), and the lower mold 206 is assembled to the lower platen (in this embodiment, the movable platen 256). Mold closing and mold opening are performed by these upper mold 204 and lower mold 206 approaching and separating from each other (the vertical direction (up-down direction) becomes the mold opening/closing direction).

Moreover, in this embodiment, as one example, a film supply mechanism (not shown) for conveying (supplying) a roll-shaped film F to the inside of the sealing mold 202 is provided. Furthermore, depending on the configuration of the workpiece W, the film F may be in a strip shape instead of a roll shape.

Next, the upper mold 204 of the sealing mold 202 will be described in detail. As shown in FIG. 3, the upper mold 204 includes an upper mold chase 210, and a cavity block 226 held thereby, a clamper 228, and the like. The upper mold chase 210 is fixed to a lower surface of a support plate 214 via support pillars 212. A cavity 208 is provided on a lower surface (the surface facing the lower mold 206) of the upper mold 204.

The clamper 228 is configured in an annular shape to surround the cavity block 226, and is assembled to be spaced apart from (floating) the lower surface of the support plate 214 via push pins 222 and clamper springs (for example, biasing members exemplified by coil springs) 224 so as to be movable up and down (however, the present invention is not limited to this assembly structure). This cavity block 226 constitutes the inner part (bottom part) of the cavity 208, and the clamper 228 constitutes the side part of the cavity 208. Moreover, the shape and number of cavities 208 provided in one upper mold 204 are appropriately set according to the shape and number of workpieces W (one or multiple).

Moreover, a suction path (hole, groove, etc.) communicating with a suction device is provided at the boundary part between the clamper 228 and the cavity block 226 (not shown). This allows the film F supplied from the film supply mechanism to be held by suction on a mold face 204a including the inner surface of the cavity 208. In addition, degassing of the cavity 208 may be performed during mold closing and resin sealing.

Moreover, in this embodiment, an upper mold heating mechanism (not shown) for heating the upper mold 204 to a given temperature is provided. This upper mold heating mechanism includes a heater (for example, an electric heating wire heater), a temperature sensor, a power supply, etc., and the heating is controlled by the control part 150. As one example, the heater is built into the upper mold chase 210 and is configured to apply heat to the overall upper mold 204 and the sealing resin R contained in the cavity 208. The upper mold 204 is heated by the heater to a given temperature (for example, 100°C to 300°C).

Next, the lower mold 206 of the sealing mold 202 will be described in detail. As shown in FIG. 3, the lower mold 206 includes a lower mold chase 240, and a lower plate 242 held thereby, and the like.

Moreover, in this embodiment, a workpiece holding part 205 for holding the workpiece W at a given position on an upper surface of the lower plate 242 is provided. This workpiece holding part 205, as one example, has a workpiece guide pin (not shown), and a suction path (hole, groove, etc.) that is arranged to penetrate through the lower plate 242 and communicates with a suction device (not shown). Specifically, one end of the suction path leads to the mold face 206a of the lower mold 206, and the other end is connected to the suction device arranged outside the lower mold 206. This makes it possible to drive the suction device to suction the workpiece W through the suction path and hold the workpiece W by suction on the mold face 206a (here, the upper surface of the lower plate 242). The configuration may be such that the holding claws for holding the outer periphery of the workpiece W (not shown) is provided instead of the suction holding mechanism or together with the suction holding mechanism. The shape and number of workpiece holding parts 205 provided in one lower mold 206 are appropriately set according to the shape and number of the workpieces W (one or multiple).

Moreover, in this embodiment, a lower mold heating mechanism (not shown) for heating the lower mold 206 to a given temperature is provided. This lower mold heating mechanism includes a heater (for example, an electric heating wire heater), a temperature sensor, a power supply, etc., and the heating is controlled by the control part 150. As one example, the heater is built into the lower mold chase 240 and is configured to apply heat to the overall lower mold 206 and the workpiece W held by the workpiece holding part 205. The lower mold 206 is heated by the heater to a given temperature (for example, 100°C to 300°C).

### (Storage Unit)

Next, the storage unit 100C included in the compression molding device 1 will be described in detail.

The molded product Wp is held by the second loader 304, unloaded from the sealing mold 202, and conveyed to the storage unit 100C. Moreover, as the holding mechanism for the molded product Wp in the second loader 304, a known holding mechanism (for example, a configuration having holding claws for gripping, a configuration having suction holes communicating with a suction device to adsorb, etc.) is configured (not shown).

As a modification example of the above conveyor, the configuration may be such that instead of the second loader 304 that moves in the X and Y directions, a conveyor (loader) that moves in the X direction to perform conveyance between units and a conveyor (loader) that moves in the Y direction to perform unloading from the sealing mold 202 (not shown) are separately included.

The storage unit 100C includes a storage magazine 104 in which multiple molded products Wp are stored. Here, known stack magazines, slit magazines, etc. are configured for the storage magazine 104.

The storage unit 100C may also be configured to include a molded product stage (not shown) on which the molded product Wp conveyed from the press unit 100B is placed.

### (Resin Sealing Operation)

Next, the operation (i.e., compression molding method) of performing resin sealing (compression molding) using the above compression molding device 1 will be described. Here, FIG. 4 to FIG. 7 are explanatory diagrams of each step, shown as front sectional views in the same direction as FIG. 3.

First, as a preparation step, a heating step (upper mold heating step) is performed to heat the upper mold 204 to a given temperature (for example, 100°C to 300°C) by adjusting it using the upper mold heating mechanism. Moreover, a heating step (lower mold heating step) is performed to heat the lower mold 206 to a given temperature (for example, 100°C to 300°C) by adjusting it using the lower mold heating mechanism. In addition, a film setting step is performed to set a new film F inside the sealing mold 202 by operating the film supply mechanism.

Before, after, or in parallel with the above preparation step, a resin preparation step is performed to prepare, as the sealing resin R for sealing, a solid or semi-solid resin having a given shape whose overall shape (to be described later) corresponds to the shape of the workpiece W.

Next, a workpiece holding step is performed to hold the workpiece W in the workpiece holding part 205 of the lower mold 206. Specifically, the workpiece W supplied from the supply magazine 102 is held by the first loader 302, loaded into the sealing mold 202, and held in the workpiece holding part 205.

After the workpiece holding step, a resin placement step is performed to place the sealing resin R prepared in the resin preparation step on top of the workpiece W held in the workpiece holding part 205 (see FIG. 4). Specifically, the sealing resin R supplied from the resin supply part 120 is held by the first loader 302, loaded into the sealing mold 202, and placed on top of the workpiece W held in the workpiece holding part 205.

Alternatively, as another example of the resin placement step, it may be performed as a step of placing the sealing resin R prepared in the resin preparation step on top of the workpiece W before the above workpiece holding step. In that case, the workpiece holding step is a step of holding the workpiece W with the sealing resin R already placed thereon in the workpiece holding part 205. That is, the first loader 302 holds the workpiece W with the sealing resin R placed thereon, loads it into the sealing mold 202, and holds it in the workpiece holding part 205. This has an advantage the workpiece W and the sealing resin R are loaded into the sealing mold 202 at one time, rather than separately.

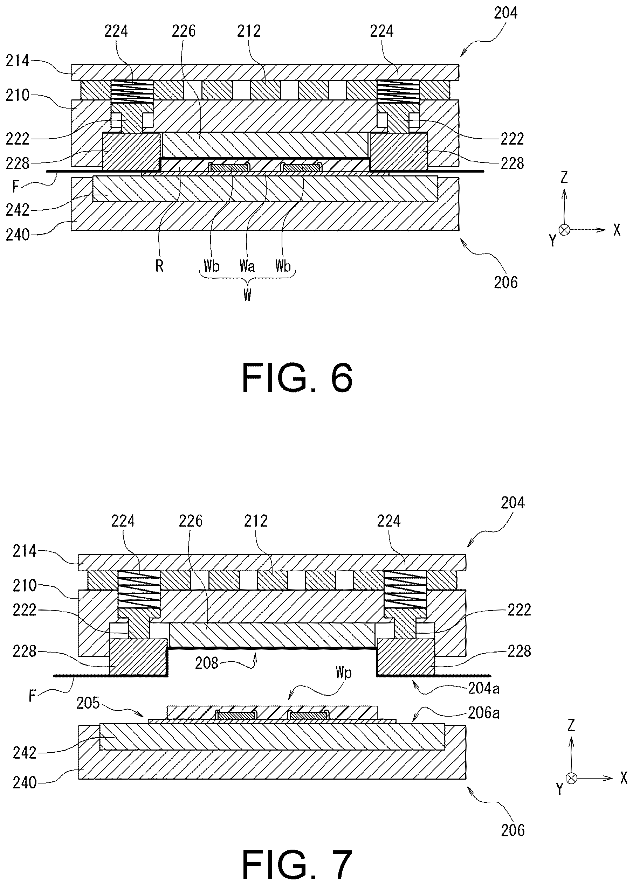

Next, a step is performed to process the workpiece W into a molded product Wp by sealing it with the sealing resin R. First, a mold closing step is performed to close the sealing mold 202 and relatively lower the cavity block 226 inside the cavity 208 to heat and pressurize the sealing resin R against the workpiece W. As a result, the sealing resin R thermally cures, completing the resin sealing (compression molding) (see FIG. 6).

As described above, for example, in conventional compression molding devices where a cavity is provided in the upper mold for workpieces W mounted with a strip type wire-connected electronic parts (semiconductor chips) Wb, there was a problem that resin sealing was difficult because the wire part of the workpiece held in the lower mold would deform due to contact with the sealing resin supplied in advance to the cavity or supplied on the workpiece during the mold closing step. Therefore, for such workpieces W, compression molding devices with cavities provided in the lower mold were generally adopted. However, there were also issues (as mentioned above) inherent to the configuration where the cavity is provided in the lower mold.

In response to the above issues, the compression molding device 1 is capable of solving the problem by adopting a configuration where the cavity 208 is provided in the upper mold 204, while also adopting a configuration in which a solid or semi-solid resin formed into a given shape corresponding to the shape of the workpiece W is configured as the sealing resin R.

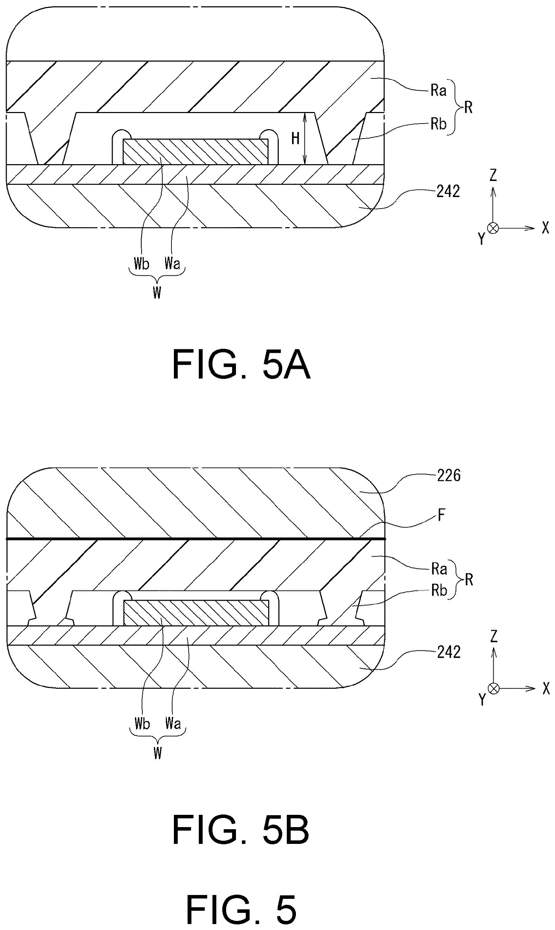

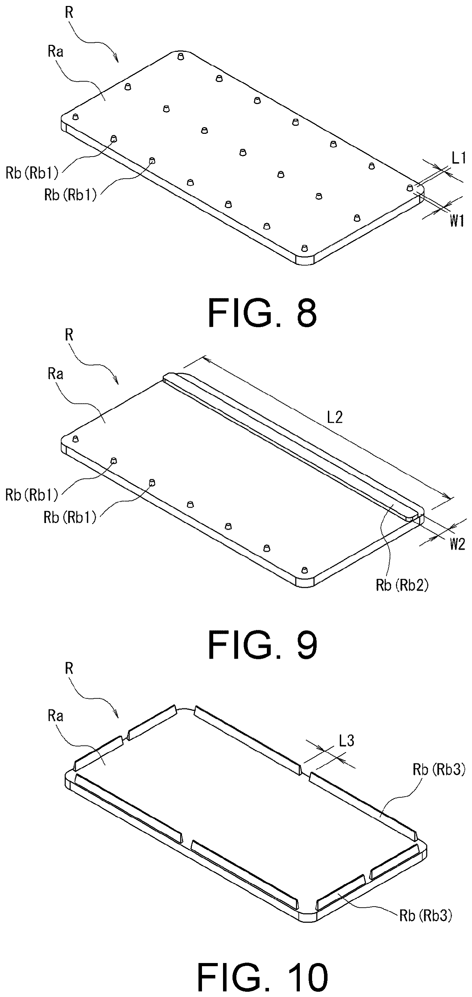

The "given shape" of the sealing resin R refers to a shape that does not contact the electronic components Wb (for electronic components Wb with wires, including wires) when placed on the substrate Wa of the workpiece W. As an example, as shown in FIG. 4, it has a shape provided with a plate-shaped or block-shaped main body part Ra and legs Rb that are intermittently (or continuously) erected on one face of the main body part Ra (the face facing the electronic components Wb of the workpiece W) (however, the present invention is not limited this shape). The main body part Ra is sized to fit inside the cavity 208 in plan view, and considering resin flow, a size slightly smaller than the shape of the cavity 208 (especially the cavity block 226) is preferable. Moreover, while the legs Rb need to have a height H (see FIG. 5A) that does not contact the electronic parts Wb, this does not exclude contact to the extent that does not cause plastic deformation of the wires. In addition, the legs Rb are positioned at locations that do not contact the electronic parts Wb in plan view of the main body part Ra, and are positioned such that the main body part Ra does not tilt when placed on the workpiece W. Furthermore, a configuration where they are arranged between the electronic parts Wb or at the outer peripheral positions of the electronic parts Wb is preferable to prevent any damage to the wiring (especially wires) of the workpiece W during molding. Moreover, the total resin amount of the plate-shaped or block-shaped main body part Ra and the legs Rb may be an amount without excess or deficiency, sufficient for one compression molding operation, or it may be a larger amount of resin. Details of specific configuration examples of the sealing resin R (FIG. 8 to FIG. 11) will be described later.

According to the above configuration, during the implementation of the mold closing step, as shown in the transition from FIG. 5A to FIG. 5B, the softening and melting of the sealing resin R progresses due to heating (note that FIG. 5A and FIG. 5B are shown as enlarged views of section V in FIG. 4). At this time, the resin (specifically, the main body part Ra) uniformly contacts all wires (see FIG. 5B). As a result, the effect of suppressing wire flow is obtained.

The inventor of the present application actually conducted experiments using the sealing resin R according to this embodiment with the compression molding device 1 described above, and confirmed that wire flow was suppressed and molding quality improved compared to a conventional compression molding device where the workpiece is held on the upper mold, the cavity is provided in the lower mold, and the sealing resin (specifically, granular resin) is supplied to that cavity.

Furthermore, because the sealing resin R is a solid or semi-solid resin, it is also possible to solve issues such as uneven scattering, residual air, and dust generation caused by granular resin as in conventional methods, as well as the difficulty in handling. In addition, even when forming thick molded products with a thickness dimension exceeding 1 mm, it is possible to prevent the film F from biting into the molded product Wp.

Note that the steps following the above-described mold closing step are the same as in the conventional compression molding method. In outline, a mold opening step is performed to open the sealing mold 202 and separate the molded product Wp from the used film F (see FIG. 7). Subsequently, a molded product unloading step is performed in which the second loader 304 unloads the molded product Wp from the sealing mold 202 and conveys it to the storage unit 100C. Furthermore, after or in parallel with the molded product unloading step, a film setting step is performed in which the film supply mechanism is activated to feed out the used film F from the sealing mold 202 and feed in a new film F into the sealing mold 202.

The above are the main steps of the compression molding method performed using the compression molding device 1. However, the order of the steps is just one example, and changes in sequence or parallel implementation are possible as long as there is no hindrance.

Next, specific configuration examples of the sealing resin R used in the compression molding method by the compression molding device 1 described above are shown in FIG. 8 to FIG. 11, and their respective features are described.

First, as a configuration common to each example shown in FIG. 8 to FIG. 11, the main body part Ra is formed in a plate shape (also may be shapes other than plate-shaped, such as block-shaped with recesses or protrusions). In addition, the legs Rb are erected on the main body part Ra at positions that do not contact the electronic components Wb of the workpiece W when the sealing resin R is placed at a given position (design-specified position) on the substrate Wa of the workpiece W, and are formed with a height H (see FIG. 5A) that ensures a distance where the main body part Ra does not contact the electronic components Wb.

In the example of the sealing resin R shown in FIG. 8, the legs Rb are formed as protrusions Rb1 arranged wholly (or partly) in a dot shape. As an example of the protrusions Rb1, they are arranged at multiple positions and formed in a shape where a ratio t of length L1 to width W1 in plan view is, as an example, 0.5 ≦ t ≦ 2. According to this, with the configuration where the legs Rb columns with a dot shape, the flow of the sealing resin R placed on the workpiece W can be suppressed during compression molding. Therefore, wire flow and the like can be suppressed, and the molding quality can be improved.

In the example of the sealing resin R shown in FIG. 9, the legs Rb are formed as protrusions Rb2 arranged partly (or wholly) in a line shape. As an example of the protrusions Rb2, they are arranged at one position (or may be at multiple positions) and formed in a shape where the ratio t of length L2 to width W2 in plan view is, as an example, t<0.5 or 2<t. According to this, by intentionally generating resin flow from the legs Rb (in this case, the protrusions Rb2) having a dam-like configuration of a given length, the filling of the sealing resin R into narrow areas of the workpiece W (for example, between the substrate Wa and the electronic components Wb that are flip-chip connected, etc.) can be promoted. Therefore, the retention of air in the molded product Wp can be prevented, and the molding quality can be improved.

In the example of the sealing resin R shown in FIG. 10, the legs Rb are formed as protrusions Rb3 that are arranged to intermittently (or may be continuously) surround over the entire periphery (referring to the outer edge region) of the main body part Ra. As an example of the protrusions Rb3, protrusions with the same configuration as Rb2 described above are formed in succession to create a circumferential shape while providing gaps L3 at given intervals. Generally, the peripheral position of the sealing resin R in the molded product Wp is the position that is cut by a dicer or the like during singulation, and because electronic components Wb do not exist there, more resin is required for sealing compared to the central position. Therefore, by providing the legs Rb (in this case, the protrusions Rb3) arranged to surround over the entire periphery as in this configuration, it is possible to supply more resin to the peripheral position while suppressing resin flow during compression molding. Furthermore, the provision of the gaps L3 promotes the discharge of gaseous components such as air from the inside (central part) to the outside.

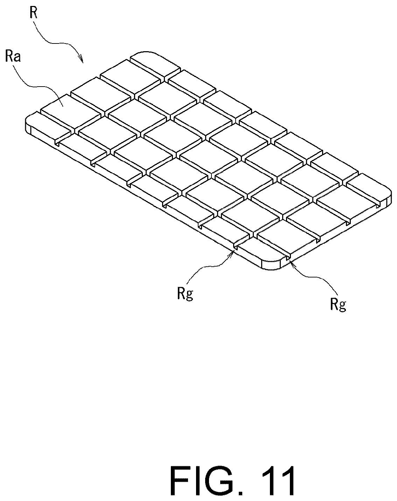

On the other hand, the example of the sealing resin R shown in FIG. 11 is a configuration example related to the other face of the main body part Ra (the face where the legs Rb are not provided, that is, the face that does not face the electronic components Wb of the workpiece W). Specifically, the main body part Ra has line-shaped groove parts Rg formed at positions where dicing is performed for singulation on the other face. According to this, reduction of dicing blade wear and reduction of dust generated during dicing can be achieved. As an example of the groove parts Rg, they are provided in a grid pattern to match the dicing positions, but the present invention is not limited thereto.

Incidentally, regarding the method of forming the sealing resin R exemplified in FIG. 8 to FIG. 11 (that is, "the formation method for sealing resin R" according to the present embodiment), it includes the following common steps. Specifically, it includes a formation step of forming a shape having a plate-shaped or block-shaped main body part Ra and legs Rb erected on the main body part Ra, and in the formation step, when the sealing resin R is placed at a given position (design setting position) on the substrate Wa of the workpiece W, the position and height of the legs Rb are set such that neither the legs Rb nor the main body part Ra contact the electronic components Wb of the workpiece W, thereby forming the sealing resin R.

As described above, by using the sealing resin R according to the present embodiment, it is possible to realize a compression molding device and compression molding method that can solve the above-mentioned problems in the configuration where a cavity is provided in the lower mold by adopting a configuration where a cavity is provided in the upper mold, prevent molding failures caused by resin flow, scattering unevenness, residual air, and dust generation, and enable the formation of molded products with large thickness dimensions. In addition, handling during supply or setting becomes particularly easy compared to granular resin and the like.

Furthermore, the present invention is not limited to the above-described embodiments and may be variously modified within a range that does not deviate from the present invention.

## Claims

1. A sealing resin for compression molding of a workpiece, the sealing resin comprising:
a plate-shaped or block-shaped main body part; and
a leg erected on one face of the main body part.

2. A sealing resin for compression molding of a workpiece having a configuration in which electronic components are mounted on a substrate,
wherein the sealing resin is formed in a shape that does not contact the electronic components when placed on the substrate.

3. The sealing resin according to claim 2, comprising:
a plate-shaped or block-shaped main body part; and
a leg erected on one face of the main body part and in contact with the substrate,
wherein the leg is erected at a position that does not contact the electronic components when placed on the substrate, and is formed at a height capable of ensuring a distance where the main body part does not contact the electronic components.

4. The sealing resin according to claim 1 or claim 3, wherein the leg is formed as a protrusion arranged wholly or partly in a dot shape.

5. The sealing resin according to claim 1 or claim 3,
wherein the leg is formed as a protrusion arranged wholly or partly in a line shape.

6. The sealing resin according to claim 1 or claim 3,
wherein the leg is formed as a protrusion arranged to continuously or intermittently surround over an entire periphery.

7. The sealing resin according to claim 1 or claim 3, comprising:
a line-shaped groove part provided through the other face of the main body part and serving as a dicing position.

8. A formation method for sealing resin for forming a sealing resin for compression molding of a workpiece having a configuration in which electronic components are mounted on a substrate, the method comprising:
a formation step of forming into a shape having a plate-shaped or block-shaped main body part and a leg erected on the main body part,
wherein the formation step includes a step of forming by setting a position and a height of the leg such that when the sealing resin is placed on the substrate, neither the leg nor the main body part contacts the electronic components.
